Europäisches Patentamt

European Patent Office

Office européen des brevets

(11) Publication number: **0 386 918**
**A2**

## (12) EUROPEAN PATENT APPLICATION

(21) Application number: **90302034.5**

(22) Date of filing: **26.02.90**

(51) Int. Cl.5: **H01R 4/04**

(30) Priority: **04.03.89 GB 8905014**

(43) Date of publication of application:
**12.09.90 Bulletin 90/37**

(84) Designated Contracting States:
**AT BE CH DE DK ES FR GB GR IT LI LU NL SE**

(71) Applicant: **THORN EMI plc**
**4 Tenterden Street**
**London W1A 2AY(GB)**

(72) Inventor: **Robins, Ian**
**308 Lansbury Drive**
**Hayes, Middlesex(GB)**

(74) Representative: **Fleming, Ian Alexander et al**
**THORN EMI Patents Limited The Quadrangle**
**Westmount Centre Uxbridge Road**
**Hayes Middlesex, UB4 0HB(GB)**

(54) **An electrical device.**

(57) In an electrical device, a thick film track (14) is applied to a substrate (16). An electrical connector (2, 12) is adhered to the thick film track (14). The connector (2, 12) comprises a lamina 14 of electrically conductive material with a plurality of holes (18).

FIG.2

## AN ELECTRICAL DEVICE

This invention relates to an electrical device comprising a substrate, a thick film track applied to the substrate and an electrical connector adhered to the thick film conductor track. In particular, though not exclusively, this invention relates to heating elements comprising thick film tracks, where the electrical connectors must have a high current carrying capacity to be able to carry the high power required of the heating element.

It is known to make connections to thick film conductor tracks using gold or aluminium wire having a diameter of the order of tens of micrometers. The wire is welded to the track by ultrasonic welding. The use of copper wire, also having a diameter of the order of tens of micrometers, has also been proposed. However, such connectors are expensive and do not have sufficiently high current carrying capability and temperature stability.

Our copending European Patent Application No. 89301453.0 discloses an electrical connector for making a connection to a thick film track wherein said connector comprises a plurality of conductive fibres braided together, each of said fibres having a diameter so as to provide sufficient stiffness to said connector and to permit adhesion of said connector to a said thick film track. Such a connector has a very good bond strength but is not easily adapted for automated component placement.

It is an object of the present invention to provide an electrical device in which at least some of the aforementioned problems are alleviated.

According to a first aspect of the present invention there is provided an electrical device comprising a substrate, a thick film track applied to the substrate and an electrical connector adhered to the thick film track, the connector comprising a lamina of electrically conductive material formed with a plurality of holes.

An electrical device according to the present invention incorporates a connector which has a low thermal mass, is easily machine placeable and produces a connection with a high sheer strength because of its low profile. The relatively large surface area of the lamina allows heat to be dissipated from the connector improving its current carrying capability and temperature stability. The high circumferential area provided by the holes also improves the sheer strength. Furthermore the connector permits a good bond strength with a thick film track because the holes allow the medium in the thick film ink adhesive to burn off, hence allowing the ink to fire correctly.

Preferably the connector further comprises a plurality of tabs protruding from a surface of the lamina. Advantageously each tab protrudes above a respective hole. The large area of connection between the connector and the adhesive provided by the tabs gives a high normal pull strength to the connection.

In an advantageous embodiment, each tab is formed of the same electrically conductive material as the lamina. This permits simple manufacture of the connector.

The provision of a tag of electrically conductive material protruding from a surface of the lamina allows easy electrical connection with wires providing a power supply.

An embodiment of the invention will now be described, by way of example only, and with reference to the accompanying drawings of which:

Figures 1a and 1b show respectively a perspective view and an enlarged sectional view of an electrical connector for incorporation in an electrical device provided in accordance with the present invention;

and Figure 2 shows a schematic representation of an electrical connector in position on a thick film track.

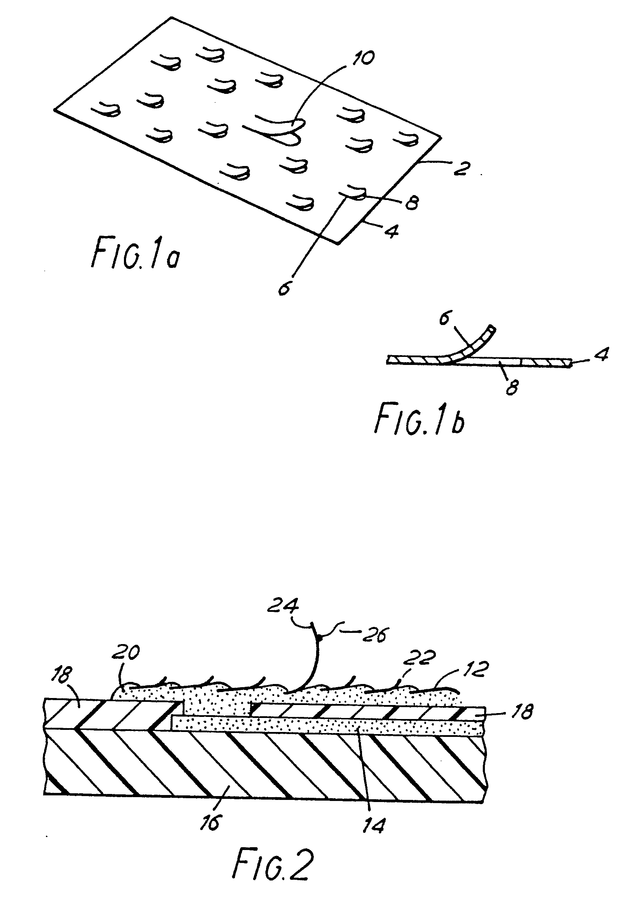

As shown in Figure 1a, an electrical connector 2 comprises a lamina 4 of sheet metal, such as nickel or stainless steel (446, 430 grade). The temperature stability of the connector is determined by the resistance to oxidation of the connector material - stainless steel (430 grade) is stable to at least 750°C. Suitable dimensions for the lamina are a thickness of 10 m and a width of 5 mm which gives a cross-sectional area, through which current can flow, of $50 \times 10^{-9} m^2$. This compares well with a wire of diameter of order 30 m which has a cross-sectional area of the order of $750 \times 10^{-'2} m^2$. The sheet metal has been pressed to form a plurality of tabs 6 protruding above a surface of the lamina 4 and above a plurality of respective holes 8. The relationship between a tab 6 and a respective hole 8 is shown more clearly in Figure 1b. The electrical connector 2 further comprises a tag 10 to which electrical connection of a wire from a power supply can be made by spot welding.

Figure 2 is a schematic representation of an electrical device with an electrical connector 12 in position on a thick film heater track 14. The track 14 is formed from a conductive ink comprising nickel and glass in the proportion of 80% to 20% by weight together with a suitable screen printing medium such as ESL 400 which is screen printed in the desired pattern onto an electrically insulative substrate 16. The materials of the track and of the connector are chosen so that they are matched for expansion coefficient to improve the bond strength.

The fired track 14 and the substrate 16 are overglazed, as indicated at 18, for protection, a part of the track 14 being exposed to permit electrical connection thereto.

The electrical connector 12 is adhered to the track 14 by a glass/metal adhesive 20 comprising nickel and glass in the proportion of 80% to 20% by weight together with a medium and then fired. During the firing process, the ink medium is removed and the metal and glass are sintered together. The holes in the connector 12 allow the medium in the adhesive to burn off, hence allowing the ink to fire correctly and improving the bond strength between the connector 12 and the track 14.

As indicated hereinbefore, each of the track 14, overglaze 18 and adhesive ink 20 for the connector 12 may separately be printed, dried and fired. Alternatively, it is envisaged that the track and overglaze may separately be printed and dried but fired in the same process after which the connector is applied and the adhesive ink dried and fired. In another process, each of the track, overglaze and adhesive ink is separately printed and dried but then all three are fired at the same time. In the latter case, advantageously, the adhesive ink is the same conductive ink as used to form the track.

The electrical connector 12 is shown as a number of tabs 22 together with a larger tag 24 to which a wire 26 has been spot welded. In this view, the holes of the connector 12 are not visible because they have been filled with adhesive 20 during the firing process.

An electrical connector as disclosed is particularly suitable for making electrical connections to heating elements of heating units disclosed in our copending European Patent Application, published under No. 0286215.

**Claims**

1. An electrical device comprising a substrate, a thick film track applied to the substrate and an electrical connector adhered to the thick film track, the connector comprising a lamina of electrically conductive material formed with a plurality of holes.

2. An electrical device according to Claim 1 wherein the lamina further comprises a plurality of protrusions.

3. An electrical device according to Claim 2 wherein each protrusion comprises a tab protruding from a surface of the lamina.

4. An electrical device according to Claim 3 wherein each tab protrudes above a respective hole.

5. An electrical device according to Claims 3 or 4 wherein each tab is formed of the same electrically conductive material as the lamina.

6. An electrical device according to any one of the preceding claims wherein the connector further comprises a tag of electrically conductive material protruding from a surface of the lamina.

FIG.1a

10

2

8

4

6

FIG.1b

6

4

8

24

26

20

22

12

18

18

16

14

FIG.2